Europäisches Patentamt

European Patent Office

Office européen des brevets

(19)

(11) **EP 0 826 972 B1**

(12) **EUROPEAN PATENT SPECIFICATION**

(45) Date of publication and mention
of the grant of the patent:
**28.04.2004 Bulletin 2004/18**

(51) Int Cl.$^7$: **G01R 23/20**, G01R 23/16

(21) Application number: **97114798.8**

(22) Date of filing: **27.08.1997**

(54) **Harmonic measurement system**

Oberwellenverzerrungsmesssystem

Système de mesure d'harmoniques

(84) Designated Contracting States:
**DE FR GB**

(30) Priority: **28.08.1996 JP 22698196**
        **09.07.1997 JP 18390497**

(43) Date of publication of application:
**04.03.1998 Bulletin 1998/10**

(73) Proprietors:
  • **MATSUSHITA ELECTRIC INDUSTRIAL CO., LTD.**
    **Kadoma-shi, Osaka 571-0050 (JP)**
  • **THE KANSAI ELECTRIC POWER CO., INC.**
    **Osaka-shi, Osaka 530 (JP)**

(72) Inventors:
  • **Niwano, Satoshi**
    **Osakafu Moriguchishi (JP)**
  • **Toda, Kazurou**
    **Osakafu Moriguchishi (JP)**
  • **Genji, Takamu**
    **Hyougoken Amagasakishi (JP)**
  • **Shinozaki, Kouichi**
    **Hyougoken Amagasakishi (JP)**

(74) Representative: **Kügele, Bernhard et al**
    **Novagraaf SA**
    **25, Avenue du Pailly**
    **1220 Les Avanchets - Geneva (CH)**

(56) References cited:
    **EP-A- 0 218 220          US-A- 4 777 381**

  • FERRERO ET AL.: "high accuracy fourier
    analysis based on synchronous sampling
    techniques" IEEE INSTR. AND MEASUREMENT
    TECHN. CONF., 12 - 14 May 1992, NEW YORK ,
    US, pages 524-527, XP000344092

**Description**

FIELD OF THE INVENTION

The present invention relates to a harmonic measurement system for measuring a harmonic included in an AC power supply and, more particularly to a system in which harmonic measurement units can be placed on a distribution line spaced apart by a large distance from each other, in which accuracy of synchronization between the units is dependent on accuracy of frequency of a distribution system, and in which generation state of harmonics can be detected accurately.

BACKGROUND OF THE INVENTION

Generally, harmonics in an AC power supply cause malfunction and failure in an equipment connected to an electric power system. In order to circumvent such power-supply fault in the equipment, it is important to measure the harmonic in the electric power system. Hereinafter, a prior art harmonic measurement system will now be described.

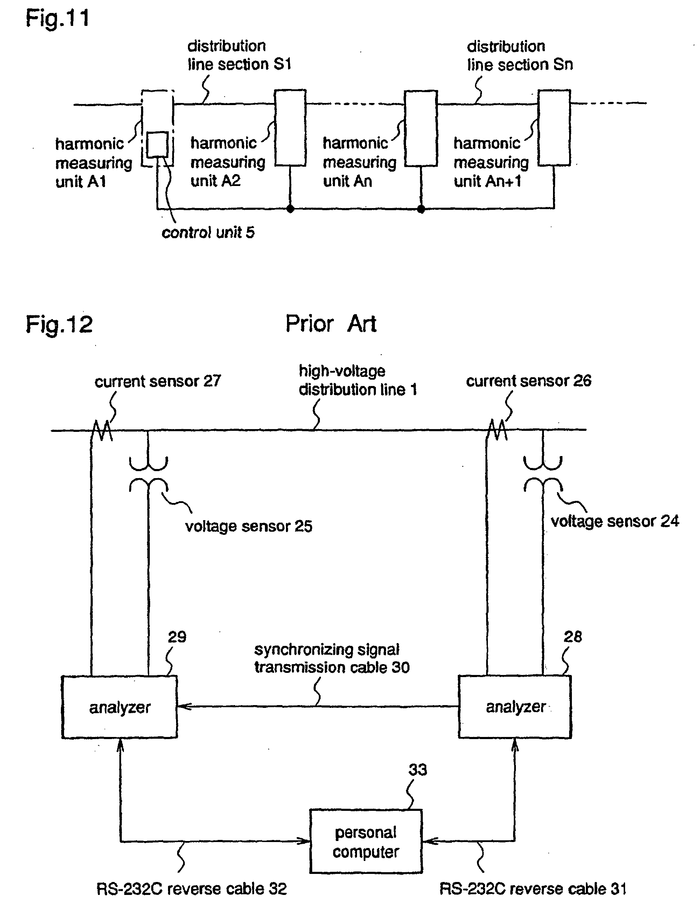

Figure 12 is a block diagram illustrating a first prior art harmonic measurement system. In the figure, reference numeral 1 designates a high-voltage distribution line, numerals 24 and 25 designate voltage sensors for detecting a voltage in the high-voltage distribution line 1, numerals 26 and 27 designate current sensors for detecting current in the high-voltage distribution line 1, numerals 28 and 29 designate digital power analyzers, numeral 30 designates a synchronizing signal transmission cable for connecting the analyzer 28 to the analyzer 29, numerals 31 and 32 designate RS-232C reverse cables, and numeral 33 designates a personal computer connected to the analyzers 28 and 29 through the RS-232C reverse cables 31 and 32, respectively. The personal computer 33 is set to run its program when a harmonic measurement analysis software stored in a floppy disk or the like is set. The analyzers 28 and 29 synchronize and capture the currents and voltages detected by the current sensors 26 and 27, and the voltage sensors 14 and 25, respectively, using sampling clock synchronizing signals which are transmitted through the synchronizing signal transmission cable 30.

An operation of the first prior art harmonic measurement system constructed above is described.

The current sensors 26 and 27, and the voltage sensors 24 and 25 which are connected to the high-voltage distribution line 1 are connected to the analyzers 28 and 29. The analyzers 28 and 29 are electrically connected to the personal computer 33 through the RS-232C reverse cables 31 and 32, respectively. The analyzer 28 is connected to the analyzer 29 through the synchronizing signal transmission cable 30. In this state, harmonic measurement is started.

The current sensors 26 and 27, and the voltage sensors 24 and 25 detect current waveform and voltage waveform of the high-voltage distribution line 1 and input the current waveform and the voltage waveform to the analyzers 28 and 29, respectively. The analyzers 28 and 29 record the current waveform and the voltage waveform sequentially with a lapse of time, analyze the recorded current waveform and voltage waveform using Fourier transform, produces waveform data for displaying waveform from fundamental component (hereinafter referred to as fundamental) to 49th harmonic component (hereinafter referred to as a harmonic) of voltage and current, and then transmits the waveform data to the personal computer 33 through the RS-232C reverse cables 31 and 32.

The personal computer 33 stores the transmitted waveform data in a hard disc and runs a harmonic analysis software stored in the floppy disk, thereby displaying the waveform from the fundamental to the 49th harmonic at the voltage detecting points and the current detecting points of the high-voltage distribution line 1 on a display thereof, by using the waveform data.

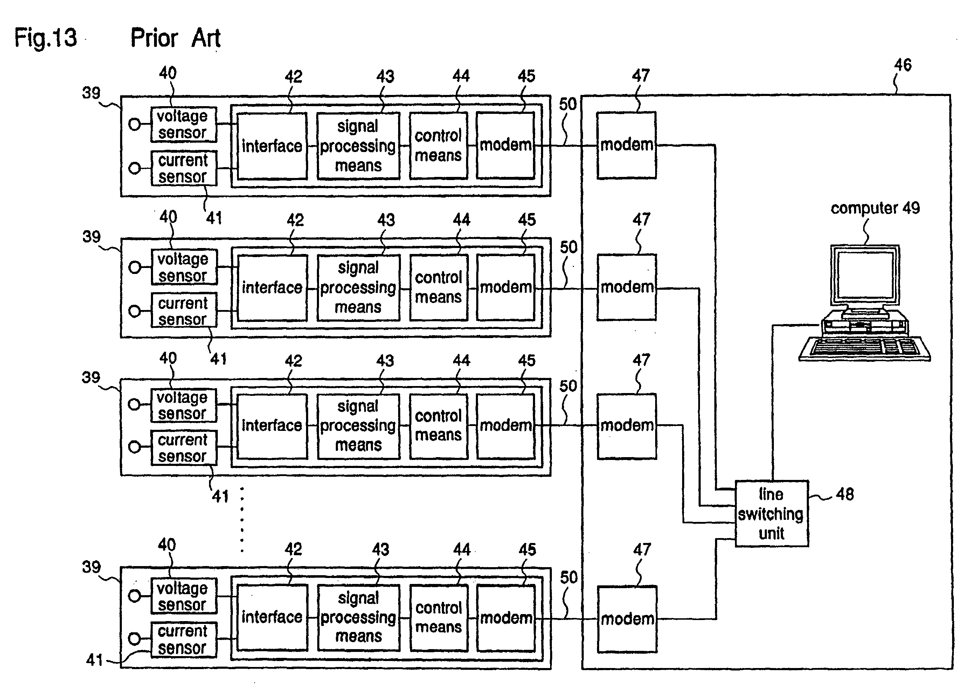

Figure 13 is a block diagram illustrating a second prior art harmonic measurement system. In the figure, reference numeral 39 designates a plurality of child stations for measuring a harmonic. Each child station 39 for measuring a harmonic includes a voltage sensor 40 and a current sensor 41 as signal input means, a signal processing means 43 connected to the voltage sensor 40 and the current sensor 41 through an interface 42, a control means 44 connected to the signal processing means 43, and a modem 45 connected to the control means 44. Reference numeral 46 designates a parent station. The parent station 46 includes a plurality of modems 47 each connected to the modem 45 in the child station over a telephone line 50, a computer 49 as an operating means, a line switching unit 48 for switching connection between the computer 49 and the plurality of modems 47.

An operation of the second prior art harmonic measurement system constructed above is described.

The voltage sensor 40 and the current sensor 41 always detect the voltage waveform and current waveform of the high-voltage distribution line (not shown), respectively and input the voltage waveform and the current waveform to a signal processing means 43 through the interface 42.

The parent station 46 transmits instructions of observation condition and observation start time or the like which are set by the computer 49 (hereinafter referred to as set menu) to the control means 44 in the child station 39 which is to perform observation, by packet transmission. When the control means 44 receives the set menu, synchronization of time of a clock of the child station 39 and time of a clock of the parent station 46 is established, thereby the child station 39 is synchronized with the parent station 46, and then the received set menu is set in the signal processing means 43.

When the control means 44 decides that it is observation start time set in the set menu, harmonic detection is started.

The signal processing means 43 samples the voltage waveform and current waveform which are input from the voltage sensor 40 and the current sensor 41 so that a result from analyzing sampling data of the voltage waveform and the current waveform using Fourier transform matches the observation condition set by the parent station 46.

The control means 44 collects sampling data of every voltage waveform and current waveform which are selected by the signal processing means 43 and transmits the same through the modem 45 to the computer 49 in the parent station 46 over the telephone line 50 every 10 minutes.

The computer 49 performs Fourier transform of sampling data of the transmitted voltage waveform and current waveform and operates harmonics power.

On the basis of the operation result, generation state of harmonics is detected. Assume that phase difference between the voltage vector and the current vector is $\theta$. When $\theta$ is $-90° < \theta < 90°$, it is judged that a harmonic power flows from the power supply, and when $\theta > 90°$ or $\theta < -90$, it is judged that the harmonic power flows from the load to the power supply.

For example, when the phase difference is $80°$ in a fifth harmonic, it is decided that the harmonic power flows from the power supply. When the phase difference is $-100°$, it is judged that the harmonics power flows from the load to the power supply. On the basis of the harmonic power operated by the computer 49, the observer decides whether the harmonic is generated in the power supply or it is generated in the load in the child station.

However, in the first prior art harmonic measurement system, as a means for establishing synchronization of harmonic measurement between the analyzers 28 and 29, sampling clocks are transmitted over the synchronizing signal transmission cable 30. Accordingly, it is necessary to establish the synchronizing signal transmission cable which can transmit high-speed sampling clocks between the analyzers 28 and 29. Therefore, in the case where there is a large distance between the analyzers 28 and 29, if impedance is suppressed to avoid collapse of waveform of the sampling clocks, the synchronizing signal transmission cable 30 becomes expensive. As a result, it is impossible to provide the analyzers 28 and 29 spaced apart from each other by a large distance.

In the second prior art harmonic measurement system, since clocks are synchronized between the parent and child stations to establish synchronization of harmonic measurements performed by the respective child stations, accuracy of synchronization depends on accuracy of clocks used by the parent and child stations. Although generation state of harmonics is detected on the basis of the phase difference between the voltage vector and the current vector, in the case where there exist harmonic sources at the power supply side and the load side of a child station currently performing observation, the phase difference at the power supply side and the phase difference at the load side cancel each other. As a result, it is impossible to detect generation of harmonics with accuracy.

## SUMMERY OF THE INVENTION

An object of the present invention is to provide a harmonic measurement system in which harmonic measuring units can be provided on a distribution line with a wide space between each other, in which accuracy of synchronism between the respective harmonic measuring units depends on accuracy of a frequency of the distribution system, in which generation state of harmonics can be detected accurately.

Other objects and advantages of the present invention will become apparent from the detailed description given hereinafter; it should be understood, however, that the detailed description and specific embodiment are given by way of illustration only, since various changes and modifications within the scope of the invention will become apparent to those skilled in the art from this detailed description.

According to a first aspect of the present invention, a harmonic measurement system comprises: a plurality of harmonic measuring units provided on a distribution line of an alternating distribution system with a certain number of phases, and detecting at least single-phase voltages and single-phase currents at positions where the harmonic measuring units are provided and, according to an operation start instruction received, calculating at least the respective harmonic components of the detected voltages and currents in synchronisation with the detected voltage; and a control unit transmitting the operation start instruction to the respective harmonic measuring units such that all of the harmonic measuring units start operation at the same time, and detecting a generation state of harmonics on the distribution line of the distribution system based on required operation results from the harmonic measuring units; characterised in that each harmonic measuring unit derives synchronisation from the detected voltage at the position on the distribution line where the respective harmonic measuring unit is provided, for the calculation of the harmonic components at said position. Therefore, since synchronism between the respective harmonic measuring units is established, a cable for transmitting synchronising signals which is provided between analyzers in the prior art system becomes unnecessary and, the harmonic measuring units can easily be placed with a wide space between each other. Further, accuracy of the synchronism between the respective harmonic measuring units depends not on accuracy of clocks used by parent and child stations in the prior art system, but on accuracy of frequency of the voltage in the distribution line.

According to a second aspect of the present invention, in the harmonic measurement system according to the first aspect, the distribution line comprises an observation target region comprising one or a plurality of distribution line sections in series, a said harmonic measuring unit being provided at opposite ends of the observation target region and at each joint between distribution line sections; and the control unit is operable to obtain admittances of each distribution line section relative to fundamental frequency and relative to harmonic frequency on the basis of the respective fundamental components and harmonic components of the voltage and currents calculated by the harmonic measuring units at opposite ends of each distribution line section and, based on the admittances obtained, detecting a generation state of harmonics within each distribution line section. Therefore, the presence of harmonic source within a distribution line section can be detected because the admittances of the distribution line section relative to fundamental frequency and relative to harmonic frequency have special values, respectively. Further, generation state of harmonic sources can be accurately detected since the admittances of distribution line section used for detecting the presence of harmonic source are not canceled each other when harmonic sources are present in the distribution line sections at opposite ends of a harmonic measuring unit currently performing measurement, unlike the case of the phase differences between the voltage vector and the current vector in the prior art system.

According to a third aspect of the present invention, in the harmonic measurement system according to the second aspect, the harmonic measuring unit, according to an operation start instruction received, calculates the fundamental component and harmonic component of the detected voltage and current, in synchronization with the detected voltage, and the control unit transmits the operation start instruction to the respective harmonic measuring units such that all of the harmonic measuring units start operation at the same time, and detects a generation state of harmonics within each distribution line section. Therefore, it is possible to provide a harmonic measurement system in which the harmonic measuring units can be provided with a wide space between each other, accuracy of the synchronism depends on the accuracy of the voltage in the distribution line, and a generation state of harmonic sources can be detected accurately.

According to a fourth aspect of the present invention, in the harmonic measurement system according to the second and third aspects, the control unit detects a generation state of harmonics within each distribution line section by displaying, successively and at prescribed time intervals, changes-over-time of the distribution of the obtained admittances, which correspond to changes of load within each distribution line section, on a coordinate plane with conductance as one coordinate axis and susceptance as the other coordinate axis. Therefore, when a harmonic source is generated, the distribution of the admittances relative to harmonic frequency changes according to a magnitude of a harmonic current generated from the harmonic source despite the distribution of the admittances relative to fundamental frequency does not change much, whereby a generation state of harmonics within each distribution line section can be visually detected with a further ease.

According to a fifth aspect of the present invention, in the harmonic measurement system according to the fourth aspect, the control unit displays changes-over-time of the distribution of the admittances corresponding to changes of load within each distribution line section, in synchronization with changes-over-time of the fundamental component of the current based on which the distribution is obtained. Therefore, the correlation between the fundamental component and the admittances is detected, and a generation state of harmonics within each distribution line section can be detected more easily.

According to a sixth aspect of the present invention, in the harmonic measurement system according to the second and third aspects, the control unit detects a generation state of harmonics within each distribution line section by obtaining a difference between the admittances obtained sequentially by subtracting an admittance from the subsequent admittance, and then displaying the difference of the admittances on a coordinate plane with conductance as one coordinate axis and susceptance as the other coordinate axis. Therefore, the variation in the distribution of the admittances corresponding to changes of load is divided into the variations in admittance corresponding to the same changes of load and the variations in admittances not corresponding to the changes of load, whereby the generation state of harmonics within each distribution line section can be detected more easily.

According to a seventh aspect of the present invention, in the harmonic measurement system according to the sixth aspect, the control unit displays, at prescribed time intervals, the distribution of the difference between the admittances on a coordinate plane with conductance as one coordinate axis and susceptance as the other coordinate axis, which distribution corresponds to changes of load within each distribution line section, in synchronization with changes-over-time of the fundamental component of the current based on which the distribution is obtained. Therefore, a separation between the variations in admittance corresponding to the changes of the same load and the variations in admittance not corresponding to the changes of the same load is achieved, and the correlation between the fundamental component and the admittances can be detected, whereby the generation state of harmonics within each distribution line section can be detected ever more easily.

According to an eighth aspect of the present invention, in the harmonic measurement system according to the second and third aspects, the control unit obtains a capacitance of a capacitor of an equivalent circuit within each distribution line section relative to fundamental frequency and relative to harmonic frequency, on the basis of the changes in the conductance and susceptance of the obtained admittance, which corresponds to changes of load within each distribution line section, and compares the capacitance of the capacitor of the equivalent circuit within each distribution line section relative to fundamental frequency, with the capacitance of the capacitor of the equivalent circuit within each distribution line section relative to harmonic frequency, to detect whether or not a harmonic source is present within each of the distribution line section. Therefore, when a harmonic source is present within a distribution line section, an equivalent circuit relative to harmonic frequency is different from an equivalent circuit relative to fundamental frequency because a circuit component constituting a harmonic source is added to the equivalent circuit relative to harmonic frequency, and thus the capacitance of the capacitor of the equivalent circuit within the distribution line section relative to fundamental frequency is not equal to that of the equivalent circuit within the same section relative to a frequency of a harmonic of any degree, whereby it is possible to detect whether or not a harmonic source is within each distribution line section, using the admittances of the distribution line section.

According to a ninth aspect of the present invention, in the harmonic measurement system according to the second and third aspects, the control unit obtains a regression line of the distribution of the obtained admittances on a coordinate plane with conductance as one coordinate axis and susceptance as the other coordinate axis, which distribution corresponds to changes of load within each distribution line section, and detects whether or not a harmonic source is present in each distribution line section based on the obtained regression line while obtaining the angle of the regression line. Therefore, it is possible to specify the angle of the regression line which corresponds to an inverse number of power factor, and a configuration of a device which is a dominant harmonic source from a quadrant of a graph where the distribution of the admittances is present.

According to a tenth aspect of the present invention, in the harmonic measurement system according to the ninth aspect, the control unit obtains, from the distribution of . the obtained admittances on a coordinate plane with conductance as one coordinate axis and susceptance as the other coordinate axis, which distribution corresponds to changes of load within each distribution line section, a regression line of the distributions relative to fundamental frequency, and estimates a circuit configuration of a passive linear load which is within each distribution line section from the obtained regression line of the distribution relative to fundamental frequency, and divides a harmonic component of a current within each distribution line section based on which the circuit configuration is estimated, into a harmonic component of a current generated from the passive linear load having the estimated circuit configuration and a harmonic component of a current generated from a harmonic source. Therefore, it is possible to detect a magnitude of a current of a harmonic source within each distribution line section.

According to an eleventh aspect of the present invention, in the harmonic measurement system according to the tenth aspect, the control unit compares the harmonic component of the current generated from the harmonic source within each distribution line section, with a prescribed reference value, to evaluate the magnitude of the harmonic component. Therefore, it is possible to easily detect a harmonic source which is most influential to the distribution system when harmonic sources are present in numeral distribution line sections.

According to a twelfth aspect of the present invention, in the harmonic measurement system according to the tenth aspect, from the harmonic component of the current generated from the harmonic source in each distribution line section, and the harmonic component of a voltage within each distribution line section based on which the circuit configuration is estimated, the control unit obtains the distribution of the admittances of each distribution line section which corresponds to changes of harmonic source within each distribution line section and, from the regression line of the obtained distribution, estimates a circuit configuration of the harmonic source which is within each distribution line sections. Therefore, it is possible to detect a circuit configuration of a harmonic source within each distribution line section.

According to a thirteenth aspect of the present invention, in the harmonic measurement system according to the first and third aspects, the control unit transmits start signals as the operation start instruction to all of the harmonic measuring units at the same time, and each of the harmonic measuring unit, after the reception of the start signal, starts the operation when a single-phase one of the detected voltages reaches a prescribed value at a prescribed number of times. Therefore, it is possible to make all the harmonic measuring units start operation at the same time, with ease.

According to a fourteenth aspect of the present invention, in the harmonic measurement system according to the first and third aspects, the control unit transmits start signals as the operation start instruction to all of the harmonic measuring units at the same time, and each of the harmonic measuring units starts the operation after a lapse of prescribed time from the reception of the start signal. Therefore, all the harmonic measuring units can start operation simultaneously after a lapse of prescribed time since the reception of the start signal.

According to a fifteenth aspect of the present invention, the harmonic measurement system according to the first and third aspects includes a transmission line between the respective harmonic measuring units and the control unit, and in the system, each of the harmonic measuring unit receives the operation start instruction and, according to the operation result transmission instruction, transmits the operation results through the transmission line to the control unit, and the control unit transmits the operation start instruction to the respective harmonic measuring units through the transmission line and, after the transmission of the operation start instruction, transmits the operation result transmission instruction to the respective harmonic measuring units through the transmission line and, detects generation states of harmonics based on the operation results transmitted from the respective harmonic measuring units. Therefore, it is possible to provide a harmonic measurement system including a transmission line for transmitting control information and operation information.

According to a sixteenth aspect of the present invention, in the harmonic measurement system according to the first and third aspects, each of the harmonic measuring units stores the operation result thereof in an information storage medium, and the control unit reads the operation result from the information storage medium in which the harmonic measuring unit stores the operation result, and detects a generation state of harmonics based on the read operation result. Therefore, unlike the case of transmitting operation results through a transmission line, a transmission rate of operation result information does not depend on a communication rate of the transmission line, whereby a massive amount of operation result information can be transmitted to the control unit at one time.

According to a seventeenth aspect of the present invention, the harmonic measurement system according to any of the first to eighth aspects includes the control unit within one of the plural harmonic measuring units. Therefore, it is possible to provide a harmonic measurement system having a control unit contained in a harmonic measuring unit.

BRIEF DESCRIPTION OF THE DRAWINGS

Figure 1 is a block diagram illustrating the configuration of a harmonic measurement system according to a first embodiment of the present invention.

Figure 2 is the configuration of a harmonic measuring unit of the harmonic measurement system shown in figure 1.

Figure 3 is a diagram illustrating a voltage waveform which shows an operation start point of harmonic analysis.

Figure 4 is a flowchart showing the operation of an analysis means.

Figure 5 is a graph illustrating one-day changes in the amplitude of a fifth harmonic of currents at opposite ends of a distribution line section respectively calculated by harmonic measuring units.

Figure 6 is a graph illustrating variations in the amplitude of the fifth harmonic of the current across the distribution line section which is obtained by subjecting the calculated data shown in figure 5 to vector difference procedure.

Figure 7 is a diagram illustrating a correlation between conductance and susceptance as components of the admittance of the distribution line section based on an one-hour amount of waveform data calculated by the harmonic measuring unit.

Figure 8 is a block diagram illustrating a harmonic measurement system according to a second embodiment of the present invention.

Figure 9 is a block diagram illustrating the configuration of a harmonic measurement system according to a third embodiment of the present invention.

Figure 10 is a block diagram illustrating the configuration of a harmonic measurement system according a fourth embodiment of the present invention.

Figure 11 is a block diagram illustrating the configuration of a harmonic measurement system according to a fifth embodiment of the present invention.

Figure 12 is a block diagram illustrating the configuration of a first prior art harmonic measurement system.

Figure 13 is a block diagram illustrating the configuration of a second prior art harmonic measurement system.

PREFERRED EMBODIMENTS OF THE INVENTION

[Embodiment 1]

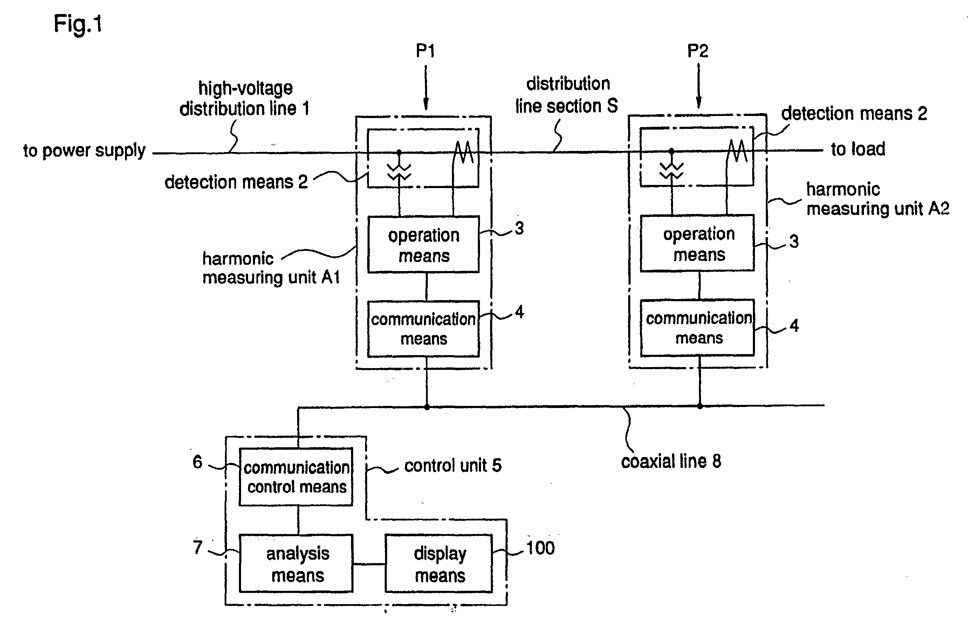

Figure 1 is a block diagram illustrating a structure of . a harmonic measurement system according to a first embodiment of the present invention. In the figure, reference numeral 1 designates a high-voltage distribution line (distribution line) of a three-phase alternating distribution system, S designates a distribution line section as an observation target section of the high-voltage distribution line 1 (hereinafter also referred to as section). Reference numerals A1 and A2 designate harmonic measuring units each comprising a detection means for detecting a voltage and a current from the high-voltage distribution line 1 at positions P1 and P2, which are positions at which the units A1 and A2 are provided (hereinafter refereed to as positions), an operation means 3 for performing harmonic analysis to the voltage and current detected by the detection means 2, and a communication means 4 for receiving control instructions including an operation start instruction and an operation result transmission instruction and transmitting the result of the operation by the operation means 3. The detection means 2 of the harmonic measuring unit A1 is provided at P1, which is at the power supply side of the section S, and the detection means 2 of the harmonic measuring unit A2 is provided at P2, which is the load side of the section S, respectively.

Reference numeral 5 designates a control unit comprising a computer. The control unit 5 comprises a transmission control means for transmitting the control instructions to the harmonic measuring units A1 and A2, and receiving the result of the operation by the operation means 3, an analysis means 7 for detecting a generation state of harmonic sources based on the operation result received from the operation means 3, and a display means 100 including CRT or the like to display the result of the analysis by the analysis means 7.

Reference numeral 8 designates a coaxial line for connecting the communication control means 6 of the control unit 5 to the respective communication means 4 of the harmonic measuring units A1 and A2, and the result of the operation by the operation means 3 are transmitted through this line 8.

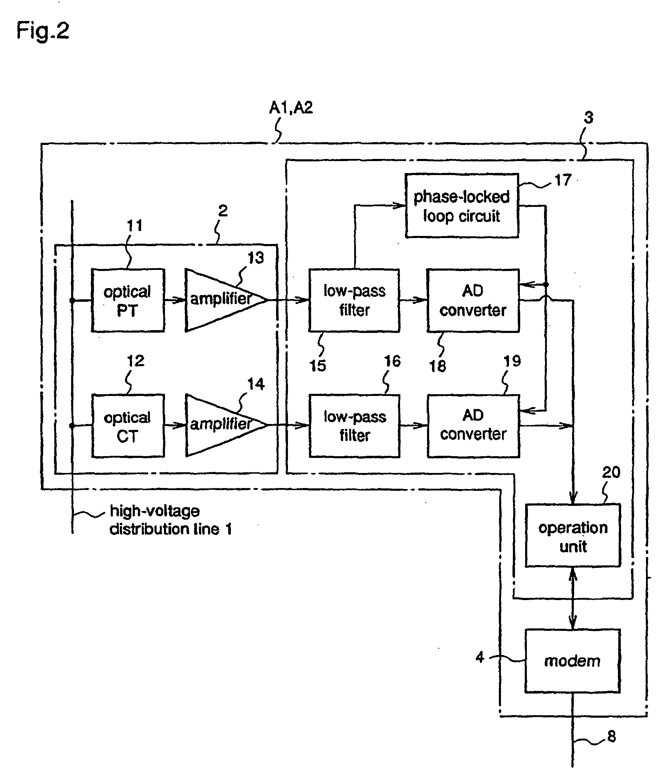

Figure 2 designates a block diagram illustrating a structure of the harmonic measuring units A1 and A2. In the figure, reference numerals 11 and 12 designate optical PT and optical CT which detect a single-phase voltage and a single-phase current in the high-voltage distribution line 1 in an insulating state, respectively. Reference numerals 13 and 14 designate amplifiers for amplifying the voltage and the current respectively detected by the optical PT 11 and the optical CT 12 so as to modulate the current and voltage to input levels for AD converters which will be described later, numeral 15 and 16 designate low-pass filters with a cutoff frequency of 3840 Hz for filtering the voltage and the current respectively amplified by the amplifiers 13 and 14 to prevent folding error caused by discrete Fourier transform, numeral 17 designates a phase-locked loop circuit for generating a synchronizing signal in synchronization with the voltage filtered by the low-pass filter 15, numeral 18 and 19 designate AD converters for sampling analog voltage and analog current which are respectively filtered by the low-pass filters 15 and 16, using the synchronizing signals generated by the phase-locked loop circuit 17, and then converting the sampled current and voltage into digital voltage and current.

Reference numeral 20 designates an operation unit for obtaining, using discrete Fourier transform, wave data (amplitude and phase) of, for example, a 49th harmonic from the respective fundamentals of the voltage and current converted into digital by the AD converters 18 and 19, to store the data into its inner memory, and transmitting the data according to the operation result transmission instruction, numeral 4 designates a modem for transmitting the operation start instruction and the operation result transmission instruction to the operation unit 20 while transmitting the wave data transmitted from the operation unit 20.

The optical PT 11, the optical CT 12, and the amplifiers 13 and 14 constitute the detection means 2. The low-pass filters 15 and 16, the phase-locked loop circuit 17, the AD converters 18 and 19, and the operation unit 20 constitute the operation means 3; and the modem constitutes the communication means 4.

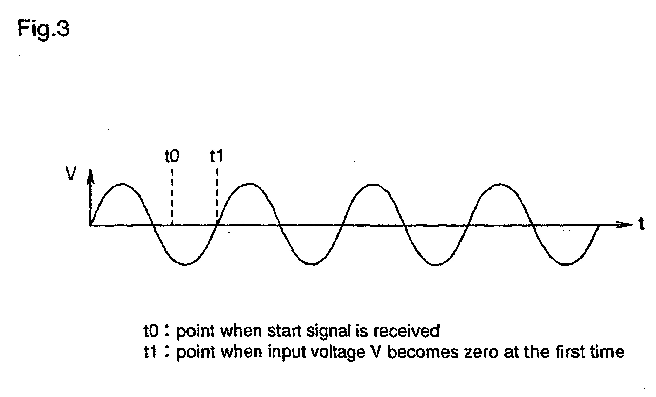

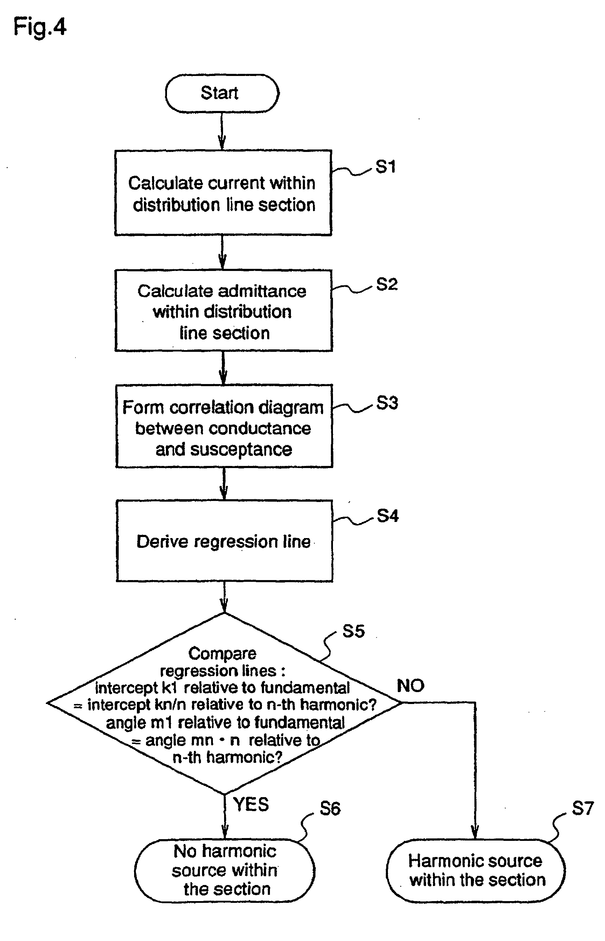

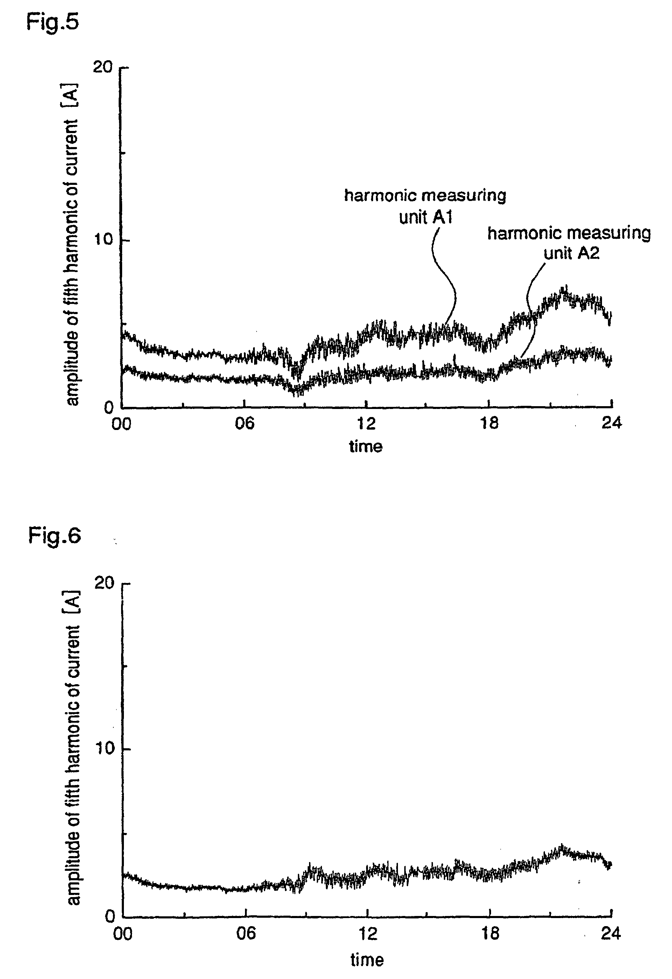

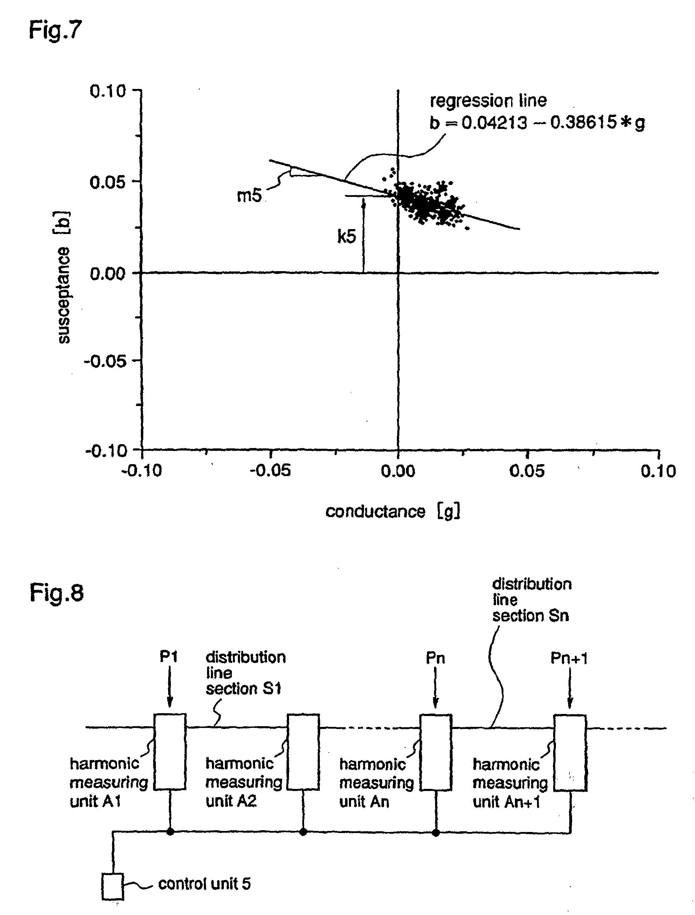

Next, a description is given of the operation of a harmonic measurement system according to the first embodiment which is configured above, with reference to figures 1 to 7. Figure 3 is a diagram of voltage waveform which shows an operation start point, figure 4 is a flowchart illustrating the operation of the analysis means, figure 5 is a graph illustrating one-day variations in amplitudes of fifth harmonics of the currents at opposite ends of a distribution line section, which amplitude is obtained by the harmonic measuring unit, and figure 6 is a graph illustrating a variation in amplitude of a fifth harmonic of a current within the section obtained by subjecting the calculated data shown in figure 5 to the vector difference, and figure 7 is a diagram showing a correlation between conductance and susceptance of the admittance of the distribution line section, which admittance is obtained based on an one-hour amount of waveform data obtained by the harmonic measuring units.

Here we will consider the operation in the case that when the control unit 5 and the harmonic measuring units A1 and A2 are on, the operation start instruction is initially transmitted from the control unit 5, followed by the operation result transmission instruction also from the control unit 5.

When the harmonic measuring units A1 and A2 are on, the optical PTs 11 and the optical CTs 12 detect voltages and currents in the high-voltage distribution line 1, respectively. The amplifiers 13 and 14 amplify the detected voltage and the detected current, respectively, and input the amplified voltage and current to the phase-locked loop circuit 17 and the AD converters 18 and 19 through the low-pass filters 15 and 16. Receiving the inputs, the phase-locked loop circuit 17 generates synchronizing signals in synchronization with the input voltage to input the signals to the AD converters 18 and 19. Receiving the synchronizing signal and the voltage and current input through the filters 15 and 16, the AD converters 18 and 19 perform sampling to the voltage and current at a timing in synchronization with the input voltage, convert the voltage and the current into digital voltage and digital current, and input them to the operation unit 20. Since the harmonic measuring units are provided in a single distribution system, the samplings performed by the two harmonic measuring units A1 and A2 become synchronous by performing sampling at the timing synchronized with the input voltage.

Under such condition, the communication control means 6 of the control unit 5 transmits start signals to the harmonic measuring units A1 and A2 at the same time, and in the harmonic measuring units A1 and A2, their modems 4 receive the start signals and transmit them to the operation units 20. Receiving the signals transmitted, the operation unit 20 detects a point t1 at which input digital voltage V becomes zero for the first time since a point t0 which is an instant when the start signal is received, and then starts the operation at that point t1. More specifically, the operation units 20 perform, for the input digital voltages and currents, harmonic analysis of sampling data obtained by 1024 times of sampling, that is, data obtained within four periods since the operation start point t1.

Then, the communication control means 6 of the control unit 5 transmits the operation result transmission instruction to the harmonic measuring unit A1, and the modem 4 of the harmonic measuring unit A1 receives the operation result transmission instruction and transmits the instruction to the operation unit 20. Receiving this instruction, the operation unit 20 transmits the waveform data of fundamental and harmonic stored in its inner memory to the modem 4 through which the waveform data is transmitted to the control unit 5.

In the control unit 5, the communication control means 6 receives the waveform data of fundamental and harmonic and transmits the data to the analysis means 7, and the analysis means 7 stores the waveform data in its inner memory.

Then, the communication control means 6 transmits the operation result transmission instruction to the harmonic measuring unit A2, and, as in the case of the harmonic measuring unit A1, the harmonic measuring unit A2 transmits the waveform data of fundamental and harmonic which is received by the control unit 5 and stored in the inner memory of the analysis means 7.

Thereafter, the control unit 5 repeats the transmission of the operation start instruction and the operation result transmission instruction to accumulate the waveform data of fundamental and harmonic obtained by the harmonic measuring units A1 and A2 in the inner memory of the analysis means 7.

When the waveform data of fundamental and harmonic is accumulated to a prescribed amount in the inner memory, the analysis means 7 reads the waveform data from the inner memory to perform analysis in the following processes shown in figures 4 to 7. Figures 5 to 7 show an analysis for a fifth harmonic only.

Initially, vector difference is calculated from amplitudes (see figure 5) and phases of a harmonic of each degree of the currents respectively obtained by the harmonic measuring units A1 and A2, to obtain amplitudes (see figure 6) and phases of each harmonic of the current across the section S (step 1).

[formula 1]

$$In_{(P2-P1)} = [\{In_{(P2)} \cdot \cos(\theta in_{(P2)}) - In_{(P1)} \cdot \cos(\theta in_{(P1)})\}^2 +$$

$$\{In_{(P2)} \cdot \sin(\theta in_{(P2)}) - In_{(P1)} \cdot \sin(\theta in_{(P1)})\}^2]^{1/2}$$

$$\theta in_{(P2-P1)} = \arctan [\{In_{(P2)} \cdot \sin(\theta in_{(P2)}) -$$

$$In_{(P1)} \cdot \sin(\theta in_{(P1)})\}/\{In_{(P2)} \cdot \cos(\theta in_{(P2)}) -$$

$$In_{(P1)} \cdot \cos(\theta in_{(P1)})\}]$$

wherein $In_{(P2-P1)}$ is an amplitude of an n-th harmonic of a current across the section S, $\theta in_{(P2-P1)}$ is a phase of the n-th harmonic of the current across the section S, $In_{(P1)}$ is an amplitude of a current at the harmonic measuring unit A1, $\theta in_{(P1)}$ is a phase of the n-th harmonic of the current at the harmonic measuring unit A1, $In_{(P2)}$ is an amplitude of an n-th harmonic of a current at the harmonic measuring unit A2, and $\theta in_{(P2)}$ is a phase of the n-th harmonic of the current at the harmonic measuring unit A2.

Next, on the harmonic of each degree of the current across the section S and the harmonic of each degree of a voltage obtained by a harmonic measuring unit A1 near power supply, admittance operation represented by formula 2 is performed to obtain an admittance relative to a frequency of the harmonic of each degree of the section S(step 2).

[Formula 2]

$$Y_n = In_{(P2-P1)} \{\cos(\theta in_{(P2-P1)} - \theta vn_{(P1)} +$$

$$i \cdot \sin(\theta in_{(P2-P1)}) - \theta vn_{(P1)})\} / V_{n(P1)}$$

$$g_n = R_e(Y_n)$$

$$b_n = I_m(Y_n)$$

wherein $Y_n$ is an admittance relative to a frequency of an n-th harmonic of the section S, $g_n$ is a conductance component of $Y_n$, $b_n$ is a susceptance component of Yn, $V_{n(P1)}$ is an amplitude of an n-th harmonic of a voltage at the harmonic measuring unit A1, $\theta v_{(P1)}$ is a phase of an n-th harmonic of the voltage through the harmonic measuring unit A1.

Then, a diagram illustrating a correlation between conductance and susceptance (see figure 7) is formed to obtain a distribution of admittances which corresponds to changes of load within the section S (step 3), and then a regression line with respect to the distribution is obtained (step 4).

Thereafter, it is judged whether or not a harmonic source is present or not within the section S based on the regression line. To be more specific, since an equivalent circuit of a high-voltage distribution line may be configured as a parallel circuit consisting of a capacitor, a resistor, and a reactor, an intercept (k5 in figure 7) of a regression line with respect to the distribution of admittances corresponding to changes of load, which is shown on a coordinate plane with conductance as one coordinate axis and susceptance as the other coordinate axis (this regression is hereinafter referred to as a regression line of admittances) corresponds to a capacitance of the capacitor, as represented by formula 3, and the angle of the regression line ($m_5$ in figure 7) corresponds to a ratio of a resistance of the resistor to an inductance of the inductor, as represented by for-

mula 4.

[Formula 3]

$$k_n = n\omega C$$

$$m_n = - R / (n\omega L)$$

wherein n is a degree of a harmonic, $k_n$ is an intercept of the regression line of admittances relative to a frequency of an n-th harmonic, $m_n$ is the angle of the regression line of admittances relative to a frequency of the n-th harmonic, $\omega$ is an angular velocity of a fundamental, C is a capacitance of the capacitor, R is a resistance of the resistor, and L is an inductance of the reactor in the eqivalent circuit.

When a harmonic source is present in the section S, an equivalent circuit with respect to harmonic frequency differs from that with respect to a frequency of fundamental in that a circuit component implementing the harmonic source is added to the former circuit. Therefore, the capacitance of the capacitor in the equivalent circuit with respect to harmonic frequency does not match the capacitance of the capacitor in the equivalent circuit with respect to fundamental frequency. Consequently, the intercept of the regression line of admittances relative to a frequency of a harmonic of each degree is not a degree multiple of the intercept of the regression line of admittances relative to a frequency of a fundamental. Further, the angle of the regression line of admittances relative to a harmonic of each degree is not a fraction of a degree multiple of the angle of the regression line of admittances relative to a frequency of a fundamental.

Therefore, the intercept $k_1$ of the regression line of admittances relative to a frequency of a fundamental is compared with an one n-th of the intercept $k_n$ of the regression line of admittances relative to a frequency of an n-th harmonic, and the angle $m_1$ of the regression line of admittances relative to the frequency of the fundamental is compared with an angle which is n-th times the angle $m_n$ of the regression line of admittances relative to the frequency of the n-th harmonic (step 5), and if the intercepts and the angles are equal, it is judged that harmonic source is not present in the section S, and if not, it is judged that the harmonic source is present in the section S (step 7).

In the above description, the distribution of the admittances is initially obtained and, on the basis of the distribution, the intercept $k_n$ of the regression line is obtained. However, when the real part $g_n = Re$ of the admittance $Y_n$ is almost zero, the imaginary part $b_n = Im(Y_n)$ of the admittance $Y_n$ of the distribution line section, which admittance is represented by formula 2, corresponds to the intercept of the regression line. Accordingly, the intercept of the regression line can be calculated directly based on the imaginary part $b_n$ of the admittance $Y_n$ of the distribution line section, which admittance is represented by formula 2.

The measured currents $In_{(P1)}$ and $In_{(P2)}$ include a current generated from a harmonic source and a current generated from a passive linear load. Since a fundamental current generated from the harmonic source is small, a regression line of admittances relative to a frequency of an n-th harmonic of a harmonic current generated from the passive linear load is estimated by multiplying the intercept $k_1$ of the regression line of admittances relative to a frequency of a fundamental by n and the angle $m_1$ of the regression line of admittances relative to the frequency of the fundamental by a fraction of n, and then, based on the conductance $g_1$ relative to the frequency of the fundamental obtained by step 2 and the estimated regression lines ($m_1/n$, $n \cdot k_1$) relative to the frequency of the n-th harmonic, the distribution of the admittances relative to the frequency of the n-th harmonic is obtained using formula 5, which n-th harmonic is of the n-th harmonic current generated from the passive linear load.

[Formula 5]

$$b_{nP} = m_1 g_1 / n + n k_1$$

wherein $b_{nP}$ is a susceptance relative to a frequency of the n-th harmonic of the n-th harmonic current generated from the passive linear load.

Then, as represented by formula 6, a difference is obtained between admittances ($g_n$, $b_n$) relative to the frequency of the n-th harmonic from the n-th harmonic current obtained in step 2, and the admittances ($g_{nP}$, $b_{nP}$) relative to the frequency of the n-th harmonic from the n-th harmonic current generated from the passive linear load, followed by obtaining the distribution of the admittances relative to the frequency of the n-th harmonic from the n-th harmonic current generated from the harmonic source.

[Formula 6]

$$g_{nA} = g_n - g_{nP}$$

$$b_{nA} = b_n - b_{nP}$$

wherein $g_{nA}$ is a conductance with respect to the frequency of the n-th harmonic from the n-th harmonic current generated from the harmonic source, and $b_{nA}$ is a susceptance with respect to the frequency of the n-th harmonic from the n-th harmonic current generated from the harmonic source.

Then, as represented by formula 7, the n-th harmonic current generated from the harmonic source is obtained from the admittances ($g_{nA}$, $b_{nA}$) relative to the frequency of the n-th harmonic from the n-th harmonic current generated from the harmonic source.

[Formula 7]

$$I_{nA} = Y_{nA} \cdot V_{n(P1)}$$

wherein $I_{nA}$ is the n-th harmonic current generated from the harmonic source, $Y_{nA}$ is the admittance ($g_{nA}$, $b_{nA}$) relative to the frequency of the n-th harmonic from the n-th harmonic current generated from the harmonic source.

Next, for each distribution line section, a comparison is performed between the n-th harmonic current generated from the harmonic source and a prescribed reference value to evaluate the magnitude of the harmonic current (the first embodiment uses only one distribution line section).

Then, the display means 100 displays the results of the analysis performed by the analysis means 7 successively. This display is performed in one of the following four methods, which method is selected by an user through a selection means (not shown).

The first display method is to display a state of the distribution of the admittances of a distribution line section S with respect to a frequency of an n-th harmonic of an n-th harmonic current generated from an harmonic source, on a correlation diagram between conductance and susceptance. More specifically, this method is to display, successively and at prescribed time intervals, changes-over-time of the distribution of admittances on a coordinate plane using conductance as one coordinate axis and susceptance as the other coordinate axis, which corresponds to changes of load within a distribution line section S. When a harmonic source is generated, the distribution of the admittances relative to harmonic frequency varies in accordance with a magnitude of a harmonic current generated from the harmonic source although the distribution of the admittances relative to frequency of fundamental does not vary much itself. This enables to perform visual detection of a generation state of harmonics within a distribution line section S with ease.

The second display method is to obtain a difference between the admittances calculated on the basis of the sampling data obtained sequentially, by subtracting the data calculated based on arbitrary sampling data from the data calculated based on the subsequent sampling data, and then display the difference of the admittances on a coordinate plane with conductance as one coordinate axis and susceptance as the other coordinate axis. As a result, the variations in the distribution of the admittances corresponding to change of load are divided into variations in admittance corresponding to the changes of same load and variations in admittance not corresponding to the changes of same load, whereby a generation state of harmonics within a distribution line section S can be detected more easily.

The third display method is to display, at prescribed time intervals, variations in the distribution of admittances corresponding to changes of load on a coordinate plane with conductance as one ordinate axis and susceptance as the other ordinate axis, in synchronization with a fundamental of the measured current $In_{(P1)}$. This enables to detect a correlation between the fundamental and the admittances, whereby a generation state of harmonics within a distribution line section S can be detected more easily.

The fourth display method is to obtain a difference between the admittances calculated on the basis of sampling data obtained sequentially, by subtracting the data calculated from arbitrary sampling data from that calculated from the subsequent sampling data, and then display, at prescribed time intervals, variations in the distribution of the difference of the admittances corresponding to changes of load, in synchronization with a fundamental of the measured current $In_{(P1)}$. This enables to achieve a separation between the variations in admittance corresponding to the changes of the same load and the variations in admittances not corresponding to the changes of the same load and to detect a correlation between the fundamental and the admittances, whereby a generation state of harmonics within a distribution line section S can be detected more easily.

Although the optical PT11 and the optical CT12 are used to detect a voltage and a current in the high-voltage distribution line 1, a transformer may be used which does not deform a frequency component of a waveform obtainable in the high-voltage distribution line 1.

Further, although a sampling Fourier system is used for analyzing harmonics, the same effects as in this case can be obtained in any system as long as amplitudes and phases of harmonics are obtainable.

Although in this case detection of harmonic source is performed to one phase of a three-phase alternating current supplied to the distribution system, this detection may be performed to two or more phases of the current, whereby unbalanced harmonic sources can be detected accurately.

Furthermore, although the operation unit 20 is set to start operation at a point when the input voltage becomes zero for the first time after the reception of the start signal, this unit may start operation at a point when the input voltage reaches a prescribed value at a prescribed number of times after the reception of the start signal..

In addition, although data are sampled at 256 times in one period in this embodiment, the same effects described above are available as long as the sampling number exceeds a double of a maximum degree of a harmonic to be analyzed.

Although in this embodiment harmonic analysis is performed on the basis of four periods of data, the same effects described above are available as long as the data amount is sufficient to perform discrete Fourier transform.

In addition, although in this embodiment a coaxial line 8 is used as a transmission line for data transmission between the harmonic measuring units and the control unit, a communication line such as a pair line may be used which is capable of data communication, and transmission by distribution line and radio transmission may be applied as a means for such data transmission. This can provide the same effects described above although as the maximum amount of data transmitted from the harmonic measuring units A1 and A2 changes.

Thus, in the first embodiment, the harmonic measuring units A1 and A2 are provided on a high-voltage distribution line 1 to perform harmonic analysis to currents and voltages obtained at their positions and, in response to operation start instruction, this harmonic analysis is performed by all of the harmonic measuring units A1 and A2 simultaneously and in synchronization with the voltage in the high-voltage distribution line 1 of the same system. Therefore, synchronism between the respective harmonic measuring units A1 and A2 is established through the high-voltage distribution line 1 and thus a cable for transmitting synchronizing signals provided between the prior art analyzers becomes unnecessary, thereby easily arranging the harmonic measuring units A1 and A2 with a wide space between them. Moreover, the accuracy of the synchronism between the harmonic measuring units A1 and A2 depends not on the accuracy of the clocks used by the parent station and the child station, but on the accuracy of the frequency of the voltage in the high-voltage distribution line 1.

Further, in the first embodiment, each operation means 3 of the harmonic measuring units A1 and A2 calculates the fundamentals and harmonics of detected voltages and currents, and the control unit 5 obtains admittances of a distribution line section S with respect to fundamental frequency and harmonic frequency, on the basis of the respective fundamentals and harmonics of the voltages and currents calculated by the operation means 3 and, based on the admittances, a generation state of harmonics within the section S is detected. Therefore, if a harmonic source is within a distribution line section S, the presence of the harmonic source can be detected since the admittances of the section S relative to the fundamental frequency and harmonic frequency have special values. Furthermore, the admittances of the section used for detecting the presence of the harmonic source are not canceled when the harmonic sources are present within the distribution line sections at the opposite sides of a harmonic measuring unit currently performing measurement, unlike the case of the phase differences between the voltage vector and the current vector in the prior art, thereby accurately detecting a generation state of harmonic sources.

Further in the first embodiment, the control unit 5 obtains the capacitance of a capacitor of an equivalent circuit of the distribution line section S, with respect to fundamental frequency and harmonic frequency, and makes a comparison between the capacitance relative to fundamental frequency and the capacitance relative to harmonic frequency to detect whether or not a harmonic source is present within the section S. Therefore, when the harmonic source is within the distribution line section S, the equivalent circuit of the section S with respect to harmonic frequency differs from the equivalent circuit with respect to fundamental frequency because a circuit component as a constituent of the harmonic source is added to the equivalent circuit of the section S with respect to the harmonic frequency. Accordingly, the capacitance of the capacitor of the equivalent circuit of the distribution line . section S with respect to the fundamental frequency does not match the capacitance of the capacitor of the equivalent circuit of the section S with respect to the harmonic frequency of each degree, thereby detecting whether or not the harmonic source is within the distribution line section S, using the admittances of the section S.

Furthermore in the first embodiment, the control unit 5 obtains the distribution of the admittances corresponding to changes of load within the distribution line section S on a correlation diagram with conductance and susceptance as its coordinate axes and, from a regression line with respect to the obtained distribution, detects whether or not a harmonic source is within the section S while obtaining the angle of the regression line. This enables to specify a configuration of an unit which is a dominant harmonic source, on the basis of the angel of the regression line that corresponds to an inverse number of a power factor and a quadrant of the correlation diagram where the distribution of admittances is present.

Still furthermore, in the first embodiment, the control unit 5 displays, successively and at prescribed time intervals, changes-over-time of the distribution of the admittances on the correlation diagram between conductance and susceptance, which correspond to changes of load within a distribution line section S, thereby visually detecting a generation state of harmonics within the section S with ease.

In addition, in the first embodiment, the control unit 5 displays changes-over-time of the distribution of admittances corresponding to changes of load within a distribution line section S, in synchronization with changes-over-time of the fundamental of the current based on which the distribution is obtained, whereby a generation state of harmonics within the distribution line section S can be detected more easily.

Moreover, in the first embodiment, the control unit 5 obtains a difference of the admittances calculated from the sampling data measured sequentially, by subtracting the data obtained based on arbitrary sampling data from that based on the subsequent sampling data, and displays, at prescribed time intervals, variations in the distribution of the difference of the admittances corresponding to changes of load, in synchronization with the fundamental of a current $In_{(P1)}$ based on which the distribution is obtained, whereby the generation state of harmonics within a distribution line section S can be detected more easily.

Further, in the first embodiment, the control unit 5 displays, at prescribed time intervals, changes-over-time of the distribution of the difference of the admittances on the correlation diagram between conductance and susceptance, which correspond to changes of load within a distribution line section S, in synchronization with changes-over-time of the fundamental of a current $In_{(P1)}$ based on which the distribution is obtained, whereby the generation state of harmonics within the section S can be detected with ever more easily.

Furthermore, in the first embodiment, the control unit 5 estimates a circuit configuration of a passive linear load which is present within a distribution line section S, from a regression line with respect to the fundamental frequency obtained from the distribution of the admittances on the correlation diagram between conductance and susceptance, which distribution corresponds to changes of load within the section S, and divides a harmonic component of a current $In_{(P1)}$ based on which the circuit configuration is estimated, into a harmonic component of the current generated from passive linear load and that of the current generated from harmonic source, whereby the magnitude of the current from a harmonic source which is present within the section S can be detected.

Still furthermore, in the first embodiment, the control unit 5 compares a harmonic of a current generated from the harmonic source with a prescribed reference to evaluate the magnitude of the harmonic, whereby a harmonic which is most influential to the distribution system can be detected with ease when harmonic sources are present in numeral distribution line section S.

In addition, in the first embodiment, the control unit 5 obtains the distribution of the admittances corresponding to changes of harmonic source within a distribution line section S, on the basis of a harmonic of the current generated from the harmonic source and a harmonic of the voltage $Vn_{(P1)}$ based on which the circuit configuration is estimated and, from the obtained regression line of the distribution, estimates a circuit configuration of the harmonic source within the section S, whereby the circuit configuration of the harmonic source within the section S can be detected.

Further, in the first embodiment, the control unit 5 transmits a start signal as an operation start instruction to the communication means 4 of both of the harmonic measuring units A1 and A2, and after receiving the start signal, each operation means 3 of the harmonic measurement units A1 and A2 starts operation when a current detected has a prescribed value at a prescribed number of times, whereby the operation of the harmonic measuring units A1 and A2 can be performed simultaneously with ease.

Furthermore, in the first embodiment, a transmission line 8 is provided between the respective communication means 4 of the harmonic measuring units A1 and A2 and the control unit 5 and, through the transmission line 8, an operation start instruction and an operation result transmission instruction are transmitted from the control unit 5 to the respective communication means 4 of the harmonic measuring units A1 and A2, and the results of the operation are transmitted from the operation means 4 to the control unit 5 through the same transmission line 8, resulting in a harmonic measurement system comprising a transmission line for transmitting control information and operation information.

[Embodiment 2]

Figure 8 is a block diagram illustrating a configuration of a harmonic measurement system according to a second embodiment of the present invention. In the figure, the same reference numerals as those in figure 1 designate same or corresponding parts. The second embodiment is different from the first embodiment in that the observation target section of a high-voltage distribution line 1 comprises a plurality of distribution line sections S1 to Sn, in that harmonic measuring units A1 to An+1 are provided at opposite ends of the high-voltage distribution line 1 comprising plural distribution line sections S1 to Sn and joints P1 to Pn+1 between the respective sections, and in that the control unit 5 transmits an operation start instruction so that all of the harmonic measuring units A1 to An+1 start operation at the same time while detecting a generation state of harmonics within a distribution line section based on the operation results from the harmonic measuring units at the opposite ends of the distribution line section.

The harmonic measurement system of the second embodiment which is above configured detects a generation state of harmonics within each distribution line section based on the operation results from the harmonic measuring units at the opposite ends of the distribution line section, as in the case of the first embodiment.

Therefore, the second embodiment can obtain the same effects achieved in the first embodiment and provide a harmonic measurement system capable of observing the high-voltage transmission line 1 in a wider range.

[Embodiment 3]

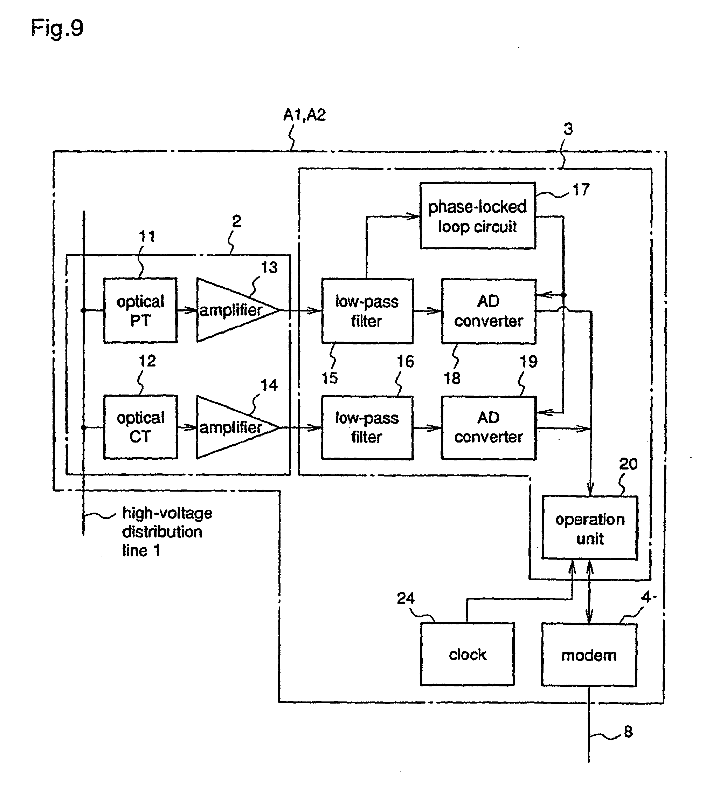

Figure 9 is a block diagram illustrating a configuration of a harmonic measuring unit used in a harmonic measurement system according to a third embodiment of the present invention. In the figure, the same reference numerals as those in the first embodiment designate same or corresponding parts. The third embodiment is different from the first embodiment in that in each of the harmonic measuring units A1 and A2 the operation unit 20 comprises a clock 24, and in that the operation unit 20 measures a time elapsed since reception of a start signal and starts operation when the elapsed time reaches a prescribed time.

In the harmonic measurement system of the third embodiment which is thus configured, the control unit transmits start signals as operation start instruction to the harmonic measuring units A1 and A2 at the same time, and the harmonic measuring units A1 and A2 start operation after a lapse of a prescribed time from the reception of the start signals through the modems 4.

Therefore, in the third embodiment, the two harmonic measuring units A1 and A2 can start operation simultaneously after a lapse of a prescribed time from reception of operation start signals.

[Embodiment 4]

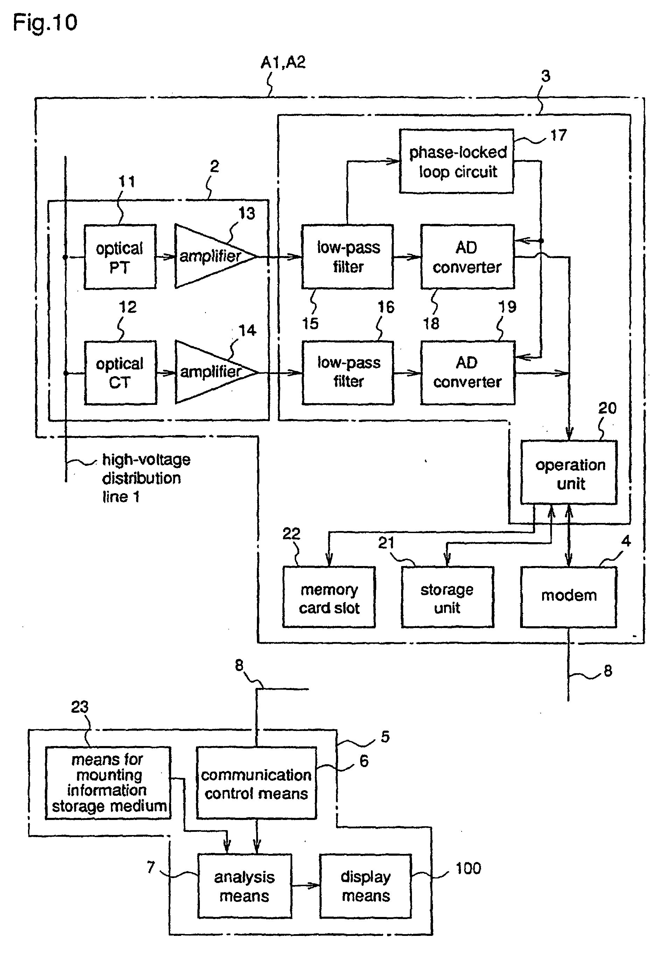

Figure 10 is a block diagram of a configuration of a harmonic measurement system according to a fourth embodiment of the present invention. In the figure, the same reference numerals as those in figures 1 and 2 designate same or corresponding parts. The fourth embodiment is different from the first embodiment in that each of the harmonic measuring units A1 and A2 comprises a storage unit 21 for storing the result of the operation by the operation unit 20 and a memory card slot 22 for making the operation result store in a memory card, in that the control unit 5 includes a means for mounting information storage medium 23 which comprises a memory card slot for reading the operation result stored in the memory card and a control means, and in that the analysis means 7 detects a generation state of harmonic sources based on the operation result read by the means for mounting information storage medium 23. A hard disk or a floppy disk may be used as the information storage medium, in place of the memory card, and a hard disk drive or a floppy disk drive may be employed as the means for mounting information storage medium, in place of the memory card slot.

In the harmonic measurement system of the fourth embodiment which is thus configured, the respective operation unit 20 of the harmonic measuring units A1 and A2 accumulate their operation results in the storage unit 21 and read the operation results from the storage unit 21 to store them in the respective memory cards mounted in the memory card slots 22. The memory cards storing the operation results within them are collected and mounted in the means for mounting information storage medium 23 of the control units 5 to read the operation results from the cards, and based on the operation results, the analysis means 7 performs analysis or detection of a generation state of harmonic sources as in the case of the first embodiment, and the display means 100 displays the result of the analysis.

Therefore, in the fourth embodiment, as in the first embodiment wherein the operation result is transmitted through the coaxial line 8, the transformation rate of operation result information does not depend on the communication speed of the coaxial line 8, which enables to send a massive amount of operation result information to the control unit 5.

[Embodiment 5]

Figure 11 is a block diagram illustrating a configuration of a harmonic measurement system according to a fifth embodiment of the present invention. In the figure, the same reference numerals as those in figure 8 designate same or corresponding parts. The fifth embodiment is different from the second embodiment in that among a plurality of harmonic measuring units A1 to An+1, a harmonic measuring unit A1 alone contains the control unit 5.

The harmonic measurement system of the fifth embodiment which is thus configured can obtain the same effects achieved in the second embodiment, and provide a harmonic measurement system having a control unit within a harmonic measuring unit.

Although in all of the above embodiments described is a case of employing a harmonic measurement system of the present invention for a three-phase alternating distributing system, any harmonic measurement system of the present invention can be applied for an alternating distribution system with an arbitrary number of phases other than the three-phase system.

**Claims**

1. A harmonic measurement system comprising:

   a plurality of harmonic measuring units (A1, A2...) provided on a distribution line (1) of an alternating distribution system with a certain number of phases, and detecting at least single-phase voltages and single-phase currents at positions where the harmonic measuring units are provided and, according to an operation start instruction received, calculating at least the respective harmonic components of the detected voltages and currents in synchronisation with the detected voltage; and
   a control unit (5) transmitting the operation start instruction to the respective harmonic measuring units such that all of the harmonic measuring units start operation at the same time, and detecting a generation state of harmonics on the distribution line of the distribution system based on required operation results from the harmonic measuring units;

   **characterised in that** each harmonic measuring unit derives synchronisation from the detected voltage at the position on the distribution line where the respective harmonic measuring unit is provided, for the calculation of the harmonic components at said position.

2. A harmonic measurement system according to claim 1, wherein the distribution line (1) comprises an observation target region comprising one or a plurality of distribution line sections (S) in series, a said harmonic measuring unit (A1, A2...) being provided at opposite ends of the observation target region and at each joint between distribution line sections;
and wherein the control unit (5) is operable to obtain admittances of each distribution line section relative to fundamental frequency and relative to harmonic frequency on the basis of the respective fundamental components and harmonic components of the voltage and currents calculated by the harmonic measuring units (A1, A2...) and, based on the admittances obtained, detecting a general state of the harmonics with each distribution line section.

3. The harmonic measuring system defined in claim 2 wherein the harmonic measuring unit (A1, A2...), according to an operation start instruction received, calculates the fundamental components and harmonic components of the detected voltage and current, in synchronization with the detected voltage, and the control unit (5) transmits the operation start instruction to the respective harmonic measuring units such that all of the harmonic measuring units start operation at the same time, and detects a generation state of harmonics within each distribution line section.

4. The harmonic measurement system according to one of claims 2 and 3 wherein the control unit (5) detects a generation state of harmonics within each distribution line section by displaying, successively and at prescribed time intervals, changes-over-time of the distribution of the obtained admittances, which corresponds to changes of load within each distribution line section, on a coordinate plane with conductance as one coordinate axis and susceptance as the other coordinate axis.

5. The harmonic measurement system defined in claim 4 wherein the control unit (5) displays changes-over-time of the distribution of the admittances, which corresponds to changes of load within each distribution line section, in synchronization with changes-over-time of the fundamental component of the current based on which the distribution is obtained.

6. The harmonic measurement system defined in one of claims 2 and 3 wherein the control unit (5) detects a generation state of harmonics within each distribution line section by obtaining a difference between the admittances obtained sequentially by subtracting an admittance from the subsequent admittance and then displaying the difference of the admittances on a coordinate plane with conductance as one coordinate axis and susceptance as the other coordinate axis.

7. The harmonic measurement system defined in claim 6 wherein the control unit (5) displays, at prescribed time intervals, the distribution of the difference between the admittances on a coordinate plane with conductance as one coordinate axis and susceptance as the other coordinate axis, which corresponds to changes of load within each distribution line section, in synchronization with changes-over-time of the fundamental component of the current based on which the distribution is obtained.

8. The harmonic measurement system defined in one of claims 2 and 3 wherein the control unit (5) obtains a capacitance of a capacitor of an equivalent circuit within each distribution line section relative to fundamental frequency and relative to harmonic frequency, on the basis of the variations in the conductance and susceptance of the obtained admittance which correspond to changes of load within each distribution line section, and compares the capacitance of the capacitor of the equivalent circuit within each distribution line section relative to fundamental frequency with the capacitance of the capacitor of the equivalent circuit within the same distribution line section relative to harmonic frequency, to detect whether or not a harmonic source is present within each distribution line section.

9. The harmonic measurement system defined in one of claims 2 and 3 wherein the control unit (5) obtains a regression line of the distribution of the obtained admittances on a coordinate plane with conductance as one coordinate axis and susceptance as the other coordinate axis, which distribution corresponds to changes of load within each distribution line section, and detects whether or not a harmonic source is present in the distribution line section based on the obtained regression line while obtaining the angle of the regression line.

10. The harmonic measurement system defined in claim 9 wherein the control unit (5) obtains, from the distribution of the obtained admittances shown on a coordinate plane with conductance as one coordinate axis and susceptance as the other coordinate axis, which distribution corresponds to changes of load within each distribution line section, a regression line of the distribution relative to fundamental frequency, and estimates a circuit configuration of a passive linear load which is within each distribution line section from the obtained regression line of the distribution relative to fundamental frequency, and divides a harmonic component of a current within each distribution line section based on which the circuit configuration is estimated, into a harmonic component of a current generated from the passive linear load having the estimated circuit configuration and a harmonic component of a current generated from a harmonic source.

11. The harmonic measurement system defined in claim 10 wherein the control unit (5) compares the harmonic component of the current generated from the harmonic source within each distribution line section with a prescribed reference value to evaluate the magnitude of the harmonic component.

12. The harmonic measurement system defined in claim 10 wherein, from the harmonic component of the current generated from the harmonic source in each distribution line section and the harmonic component of a voltage within each distribution line section based on which the circuit configuration is estimated, the control unit (5) obtains the distribution of the admittances which corresponds to changes of harmonic source within each distribution line section and, from the regression line of the obtained distribution, estimates a circuit configuration of the harmonic source which is within each distribution line section.

13. The harmonic measurement system defined in one of claims 1 and 3 wherein the control unit (5) transmits start signals as the operation start instruction to all of the harmonic measuring units at the same time, and each of the harmonic measuring units (A1, A2...), after the reception of the start signal, starts the operation when a single-phase one of the detected voltages reaches a prescribed value at a prescribed number of times.

14. The harmonic measurement system defined in one of claims 1 and 3 wherein the control unit (5) transmits start signals as the operation start instruction to all of the harmonic measuring units at the same time, and each of the harmonic measuring units (A1, A2...) starts the operation after a lapse of prescribed time from the reception of the start signal.

15. The harmonic measurement system defined in one of claims 1 and 3 including a transmission line (8) between the respective harmonic measuring units (A1, A2...) and the control unit (5), wherein each of the harmonic measuring units (A1, A2...) receives the operation start instruction and, according to the operation result transmission instruction, transmits the operation result through the transmission line (8) to the control unit (5), and the control unit (5) transmits the operation start instruction to the respective harmonic measuring units through the transmission line (8) and, after the transmission of the operation start instruction, transmits the operation result transmission instruction to the respective harmonic measuring units (A1, A2...) through the transmission line (8) and, detects generation states of harmonics based on the operation results transmitted from the respective harmonic measuring units (A1, A2...).

16. The harmonic measurement system defined in one of claims 1 and 3 wherein each of the harmonic measuring units (A1, A2...) stores the operation result thereof in an information storage medium, and the control unit (5) reads the operation result from the information storage medium in which the harmonic measuring unit stores the operation result, and detects a generation state of harmonics based on the read operation result.

17. The harmonic measurement system defined in any of claims 1 to 9 including the control (5) unit within one of the plural harmonic measuring units (A1, A2...).

**Patentansprüche**

1. Oberwellen-Messsystem mit

einer Vielzahl von Oberwellen-Messeinheiten (A1, A2 ...), die an einer Verteilungsleitung (1) eines Wechselverteilungssystems mit einer bestimmten Anzahl von Phasen vorgesehen sind und die zumindest Einphasenspannungen und Einphasenströme an Stellen ermitteln, an denen die Oberwellen-Messeinheiten vorgesehen sind, und die entsprechend einem empfangenen Betriebsstartbefehl zumindest die jeweiligen harmonischen Teilschwingungen der ermittelten Spannungen und Ströme synchron mit der ermittelten Spannung berechnen; und

einer Steuereinheit (5), die den Betriebsstartbefehl so zu den jeweiligen Oberwellen-Messeinheiten sendet, dass alle Oberwellen-Messeinheiten den Betrieb gleichzeitig starten, und die einen Erzeugungszustand der Oberwellen an der Verteilungsleitung des Verteilungssystems aufgrund der von den Oberwellen-Messeinheiten angeforderten Betriebsergebnissen ermittelt, **dadurch gekennzeichnet, dass** jede Oberwellen-Messeinheit die Synchronisation aus der ermittelten Spannung an der Stelle an der Verteilungsleitung ableitet, an der die jeweilige Oberwellen-Messeinheit vorgesehen ist, um die harmonischen Teilschwingungen an dieser Stelle zu berechnen.

2. Oberwellen-Messsystem nach Anspruch 1, **dadurch gekennzeichnet,**

**dass** die Verteilungsleitung (1) einen Beobachtungszielbereich mit einem oder mehreren hintereinandergeschalteten Verteilungsleitungsabschnitten (S) aufweist, wobei die Oberweilen-Messeinheiten (A1, A2 ...) an jedes gegenüberliegendes Ende des Beobachtungszielbereichs und an jeder Verbindungsstelle zwischen den Verteilungsleitungsabschnitten vorgesehen ist, und

dass die Steuereinheit (5) so arbeiten kann, dass sie Admittanzen jedes Verteilungsleitungsabschnitts in Bezug zur Grundfrequenz und in Bezug zur Oberwellenfrequenz aufgrund der jeweiligen Grundschwingungen und harmonischen Teilschwingungen der von den Oberwellen-Messeinheiten (A1, A2 ...) berechneten Spannung und Ströme erhält und aufgrund der erhaltenen Admittanzen einen Erzeugungszustand der Oberwellen in jedem Verteilungsleitungsabschnitt ermittelt.

3. Oberwellen-Messsystem nach Anspruch 2, **dadurch gekennzeichnet, dass** jede Oberwellen-Messeinheit (A1, A2 ...) entsprechend einem empfangenen Betriebsstartbefehl die Grundschwingungen und harmonischen Teilschwingungen der ermittelten Spannung und des ermittelten Stroms synchron mit der ermittelten Spannung berechnet und dass die Steuereinheit (5) den Betriebsstartbefehl so zu den jeweiligen Oberwellen-Messeinheiten sendet, dass alle Oberwellen-Messeinheiten den Betrieb gleichzeitig beginnen, und einen Erzeugungszustand der Oberwellen in jedem Verteilungsleitungsabschnitt ermittelt.

4. Oberwellen-Messsystem nach einem der Ansprüche 2 und 3, **dadurch gekennzeichnet, dass** die Steuereinheit (5) einen Erzeugungszustand der Oberwellen in jedem Verteilungsleitungsabschnitt durch aufeinanderfolgendes und in festgelegten Zeitabständen erfolgendes Anzeigen der Umschaltzeit der Verteilung der erhaltenen Admittanzen, die Laständerungen in jedem Verteilungsleitungsabschnitt entspricht, auf einer Koordinatenebene mit der Konduktanz als der einen Koordinatenachse und der Suszeptanz als der anderen Koordinatenachse ermittelt.

5. Oberwellen-Messsystem nach Anspruch 4, **dadurch gekennzeichnet, dass** die Steuereinheit (5) die Umschaltzeit der Verteilung der Admittanzen, die Laständerungen in jedem Verteilungsleitungsabschnitt entspricht, synchron mit der Umschaltzeit der Grundschwingung des Stroms anzeigt, aufgrund deren die Verteilung erhalten wird.

6. Oberwellen-Messsystem nach einem der Ansprüche 2 und 3, **dadurch gekennzeichnet, dass** die Steuereinheit (5) einen Erzeugungszustand der Oberwellen in jedem Verteilungsleitungsabschnitt durch Erhalten einer Differenz zwischen den Admittanzen, die der Reihe nach durch Subtrahieren einer Admittanz von der nachfolgenden Admittanz erhalten werden, und durch anschließendes Anzeigen der Differenz der Admittanzen auf einer Koordinatenebene mit der Konduktanz als der einen Koordinatenachse und der Suszeptanz als der anderen Koordinatenachse ermittelt.

7. Oberwellen-Messsystem nach Anspruch 6, **dadurch gekennzeichnet, dass** die Steuereinheit ( 5) in festgelegten Zeitabständen die Verteilung der D ifferenz zwischen den Admittanzen auf einer Koordinatenebene mit der Konduktanz als der einen Koordinatenachse und der Suszeptanz als der anderen Koordinatenachse, die Laständerungen in jedem Verteilungsleitungsabschnitt entspricht, synchron mit der Umschaltzeit der Grundschwingung des Stroms anzeigt, aufgrund deren die Verteilung erhalten wird.

8. Oberwellen-Messsystem nach einem der Ansprüche 2 und 3, **dadurch gekennzeichnet, dass** die Steuereinheit (5) eine Kapazität eines Kondensators einer analogen Schaltung in jedem Verteilungsleitungsabschnitt in Bezug zur Grundfrequenz und in Bezug zur Oberwellenfrequenz aufgrund der Änderungen der Konduktanz und Suszeptanz der erhaltenen Admittanz, die Laständerungen in jedem Verteilungsleitungsabschnitt entsprechen, erhält und die Kapazität des Kondensators der analogen Schaltung in jedem Verteilungsleitungsabschnitt in Bezug zur Grundfrequenz mit der Kapazität des Kondensators der analogen Schaltung in demselben Verteilungsleitungsabschnitt in Bezug zur Oberwellenfrequenz vergleicht, um zu ermitteln, ob eine Oberwellenquelle in jedem Verteilungsleitungsabschnitt vorhanden ist oder nicht.

9. Oberwellen-Messsystem nach einem der Ansprüche 2 und 3, **dadurch gekennzeichnet, dass** die Steuereinheit (5) eine Regressionsgerade der Verteilung der erhaltenen Admittanzen auf einer Koordinatenebene mit der Konduktanz als der einen Koordinatenachse und der Suszeptanz als der anderen Koordinatenachse, wobei die Verteilung Laständerungen in jedem Verteilungsleitungsabschnitt entspricht, erhält und aufgrund der erhaltenen Regressionsgeraden beim Ermitteln des Winkels der Regressionsgeraden ermittelt, ob eine Oberwellenquelle in dem Verteilungsleitungsabschnitt vorhanden ist oder nicht.

10. Oberwellen-Messsystem nach Anspruch 9, **dadurch gekennzeichnet, dass** die Steuereinheit (5) aus der Verteilung der erhaltenen Admittanzen, die auf einer Koordinatenebene mit der Konduktanz als der einen Koordinatenachse und der Suszeptanz als der anderen Koordinatenachse dargestellt ist, wobei die Verteilung Laständerungen in jedem Verteilungsleitungsabschnitt entspricht, eine Regressionsgerade der Verteilung in Bezug zur Grundfrequenz erhält und eine Schaltungsanordnung mit einer passiven linearen Last, die in jedem Verteilungsleitungsabschnitt vorliegt, aus der erhaltenen Regressionsgeraden in Bezug zur Grundfrequenz bestimmt und eine harmonische Teilschwingung eines Stroms in jedem Verteilungsleitungsabschnitt, aufgrund deren die Schaltungsanordnung bestimmt wird, in eine harmonische Teilschwingung eines Stroms, der aus der passiven linearen Last erzeugt wird, die die ermittelte Schaltungsanordnung hat, und in eine harmonische Teilschwingung eines von einer Oberwellenquelle erzeugten Stroms unterteilt.

11. Oberwellen-Messsystem nach Anspruch 10, **dadurch gekennzeichnet, dass** die Steuereinheit (5) die harmonische Teilschwingung des von der Oberwellenquelle erzeugten Stroms in jedem Verteilungsleitungsabschnitt mit einem festgelegten Referenzwert vergleicht, um die Größe der harmonischen Teilschwingung zu beurteilen.

12. Oberwellen-Messsystem nach Anspruch 10, **dadurch gekennzeichnet, dass** die Steuereinheit (5) aus der harmonischen Teilschwingung des von der Oberwellenquelle in jedem Verteilungsleitungsabschnitt erzeugten Stroms und der harmonischen Teilschwingung einer Spannung in jedem Verteilungsleitungsabschnitt, aufgrund deren die Schaltungsanordnung bestimmt wird, die Verteilung der Admittanzen, die Laständerungen der Oberwellenquelle in jedem Verteilungsleitungsabschnitt entspricht, erhält und aus der Regressionsgeraden der erhaltenen Verteilung eine Schaltungsanordnung der Oberwellenquelle, die in jedem Verteilungsleitungsabschnitt liegt, bestimmt.

13. Oberwellen-Messsystem nach einem der Ansprüche 1 und 3, **dadurch gekennzeichnet, dass** die Steuereinheit (5) Startsignale als Betriebsstartbefehl zu allen Oberwellen-Messeinheiten gleichzeitig sendet und dass jede der Oberwellen-Messeinheiten (A1, A2 ...) nach Empfang des Startsignals den Betrieb beginnt, wenn eine Einphasenspannung der ermittelten Spannungen einen festgelegten Wert zu einer festgelegten Anzahl von Zeitpunkten erreicht.

14. Oberwellen-Messsystem nach einem der Ansprüche 1 und 3, **dadurch gekennzeichnet, dass** die Steuereinheit (5) Startsignale als Betriebsstartbefehl zu allen Oberwellen-Messeinheiten gleichzeitig sendet und dass jede der Oberwellen-Messeinheiten (A1, A2 ...) den Betrieb nach dem Verstreichen einer festgelegten Zeit nach dem Empfang des Startsignals beginnt.

15. Oberwellen-Messsystem nach einem der Ansprüche 1 und 3, das eine Übertragungsleitung (8) zwischen den jeweiligen Oberwellen-Messeinheiten (A1, A2 ...) und der Steuereinheit (5) aufweist, **dadurch gekennzeichnet, dass** jede der Oberwellen-Messeinheiten (A1, A2 ...) den Betriebsstartbefehl empfängt und entsprechend dem Betriebsergebnis-Sendebefehl das Betriebsergebnis über die Übertragungsleitung (8) zu der Steuereinheit (5) sendet und dass die Steuereinheit (5) den Betriebsstartbefehl über die Übertragungsleitung (8) zu den einzelnen Oberwellen-Messeinheiten sendet und nach dem Senden des Betriebsstartbefehls den Betriebsergebnis-Sendebefehl über die Übertragungsleitung (8) zu den einzelnen Oberwellen-Messeinheiten (A1, A2 ...) sendet und Erzeugungszustände der Oberwellen aufgrund des von den einzelnen Oberwellen-Messeinheiten (A1, A2 ...) gesendeten Betriebsergebnisses ermittelt.

16. Oberwellen-Messsystem nach einem der Ansprüche 1 und 3, **dadurch gekennzeichnet, dass** jede der Oberwellen-Messeinheiten (A1, A2 ...) ihr Betriebsergebnis in einem Informationsspeichermedium speichert und dass die Steuereinheit (5) das Betriebsergebnis aus dem Informationsspeichermedium, in dem die Oberwellen-Messeinheit das Betriebsergebnis speichert, liest und einen Erzeugungszustand der Oberwellen aufgrund des gelesenen Betriebsergebnisses ermittelt.

17. Oberwellen-Messsystem nach einem der Ansprüche 1 bis 9, das die Steuereinheit (5) in einer der mehreren Oberwellen-Messeinheiten (A1, A2 ...) aufweist.

**Revendications**

1. Système de mesure d'harmoniques comprenant :

une pluralité d'unités de mesure d'harmoniques (A1, A2...) disposées sur une ligne de distribution (1) d'un système de distribution de courant alternatif ayant un certain nombre de phases, et détectant au moins des tensions d'une seule phase et des courants d'une seule phase à des positions où les unités de mesure d'harmoniques sont prévues et, conformément à une instruction de début d'opération reçue, calculant au moins les composantes des harmoniques respectives des tensions détectées et des courants en synchronisation avec la tension détectée, et

une unité de commande (5) transmettant une instruction de début d'opération aux unités de mesure d'harmoniques respectives de sorte que toutes les unités de mesure d'harmoniques commencent l'opération en même temps, et détectant un état de génération des harmoniques sur la ligne de distribution du système de distribution sur la base des résultats de l'opération demandée à partir des unités de mesure d'harmoniques,

**caractérisé en ce que** chaque unité de mesure d'harmoniques obtienne une synchronisation par rapport à la tension détectée à la position sur la ligne de distribution où est disposée l'unité de mesure d'harmoniques respective pour le calcul des composantes d'harmoniques à ladite position.

2. Système de mesure d'harmoniques selon la revendication 1, dans lequel la ligne de distribution (1) comprend une région cible d'observation comprenant une ou plusieurs sections de ligne de distribution (S) en série, une dite unité de mesure d'harmoniques (A1, A2 ...) étant disposée à des extrémités opposées de la région cible d'observation et à chaque jonction entre les sections de la ligne de distribution,
et dans lequel l'unité de commande (5) peut être mise en oeuvre pour obtenir les admittances de chaque section de ligne de distribution par rapport à la fréquence fondamentale et par rapport aux fréquences des harmoniques sur la base des composantes fondamentales respectives et des composantes d'harmoniques de la tension et des courants calculés par les unités de mesure d'harmoniques (A1, A2 ...) et, sur la base des admittances obtenues, détectant un état général des harmoniques avec chaque section de ligne de distribution.

3. Système de mesure d'harmoniques selon la revendication 2, dans lequel l'unité de mesure d'harmoniques (A1, A2 ...), conformément à une instruction de début d'opération reçue, calcule les composantes fondamentales et les composantes d'harmoniques de la tension et du courant détectés, en synchronisation avec la tension détectée, et l'unité de commande (5) transmet l'instruction de début d'opération aux unités de mesure d'harmoniques respectives de sorte que toutes les unités de mesure d'harmoniques commencent l'opération en même temps, et détectent un état de génération des harmoniques à l'intérieur de chaque section de ligne de distribution.

4. Système de mesure d'harmoniques selon l'une des revendications 2 et 3, dans lequel l'unité de commande (5) détecte un état de génération des harmoniques à l'intérieur de chaque section de ligne de distribution en affichant, successivement et à des intervalles de temps prescrits, des variations dans le temps de la distribution des admittances obtenues, qui correspondent à des variations de la charge à l'intérieur de chaque section de ligne de distribution, sur un plan de coordonnées, la conductance constituant un axe de coordonnées et la susceptance l'autre axe de coordonnées.

5. Système de mesure d'harmoniques selon la revendication 4, dans lequel l'unité de commande (5) affiche des variations dans le temps de la distribution des admittances, qui correspondent à des variations de charge à l'intérieur de chaque section de ligne de distribution, en synchronisation avec des variations dans le temps de la composante fondamentale du courant sur la base de laquelle la distribution est obtenue.

6. Système de mesure d'harmoniques selon l'une des revendications 2 et 3, dans lequel l'unité de commande (5) détecte un état de génération des harmoniques à l'intérieur de chaque section de ligne de distribution en obtenant une différence entre les admittances obtenues séquentiellement par soustraction d'une admittance de l'admittance suivante et en affichant ensuite la différence des admittances sur un plan de coordonnées, la conductance constituant un axe de coordonnées et la susceptance l'autre axe de coordonnées.

7. Système de mesure d'harmoniques selon la revendication 6, dans lequel l'unité de commande (5) affiche, à des intervalles de temps prescrits la distribution de la différence entre les admittances sur un plan de coordonnées, la conductance étant un axe de coordonnées et la susceptance l'autre axe de coordonnées, qui correspondent à des variations de charge à l'intérieur de chaque section de ligne de distribution, en synchronisation avec des variations dans le temps de la composante fondamentale du courant sur la base duquel la distribution est obtenue.

8. Système de mesure d'harmoniques selon l'une des revendications 2 et 3, dans lequel l'unité de commande (5) obtient une capacité d'un condensateur d'un circuit équivalent à l'intérieur de chaque section de ligne de distribution par rapport à la fréquence fondamentale et par rapport à la fréquence d'harmoniques, sur la base des variations de la conductance et de la susceptance de l'admittance obtenue qui correspondent à des variations de charge à l'intérieur de chaque section de ligne de distribution, et comparent la capacité du condensateur du circuit équivalent à l'intérieur de chaque section de lignes de distribution par rapport à la fréquence fondamentale, à la capacité du condensateur du circuit équivalent à l'intérieur de la même section de ligne de distribution par rapport à la fréquence d'harmoniques, afin de détecter si une source d'harmoniques est présente ou non à l'intérieur de chaque section de ligne de distribution.

9. Système de mesure d'harmoniques selon l'une des revendications 2 et 3, dans lequel l'unité de commande (5) obtient une droite de régression de la distribution des admittances obtenues sur un plan de coordonnées, la conductance étant un axe de coordonnées et la susceptance l'autre axe de coordonnées, laquelle distribution correspond à des variations de charge à l'intérieur de chaque section de ligne de distribution, et détecte si une source d'harmoniques est ou non présente dans la section de ligne de distribution sur la base de la droite de régression obtenue tout en obtenant l'angle de la droite de régression.

10. Système de mesure d'harmoniques selon la revendication 9, dans lequel l'unité de commande (5) obtient, à partir de la distribution des admittances obtenues présentée sur un plan de coordonnées, la conductance étant un axe de coordonnées et la susceptance l'autre axe de coordonnées, laquelle distribution correspond aux variations de charge à l'intérieur de chaque section de ligne de distribution, une droite de régression de la distribution par rapport à la fréquence fondamentale, et estime une configuration de circuit d'une charge linéaire passive qui est à l'intérieur de chaque section de ligne de distribution d'après la droite de régression obtenue de la distribution par rapport à la fréquence fondamentale, et divise une composante d'harmoniques d'un courant à l'intérieur de chaque section de ligne de distribution sur la base de laquelle la configuration de circuit est estimée, en une composante d'harmoniques d'un courant généré à partir de la charge linéaire passive présentant la configuration de circuit estimée et une composante d'harmoniques d'un courant généré à partir d'une source d'harmoniques.

11. Système de mesure d'harmoniques selon la revendication 10, dans lequel l'unité de commande (5) compare la composante d'harmoniques du courant généré à partir de la source d'harmoniques à l'intérieur de chaque section de ligne de distribution à une valeur de référence prescrite pour évaluer l'amplitude de la composante d'harmoniques.

12. Système de mesure d'harmoniques selon la revendication 10, dans lequel, à partir de la composante d'harmoniques du courant généré à partir de la source d'harmoniques dans chaque section de ligne de distribution et de la composante d'harmoniques d'une tension à l'intérieur de chaque section de ligne de distribution sur la base de laquelle la configuration du circuit est estimée, l'unité de commande (5) obtient la distribution des admittances qui correspond à des variations de la source d'harmoniques à l'intérieur de chaque section de ligne de distribution et, d'après la droite de régression de la distribution obtenue, estime une configuration de circuit de la source d'harmoniques qui est à l'intérieur de chaque section de ligne de distribution.

13. Système de mesure d'harmoniques selon l'une des revendications 1 et 3, dans lequel l'unité de commande (5) transmet des signaux de début en tant qu'instruction de début d'opération vers toutes les unités de mesure d'harmoniques en même temps, et chacune des unités de mesure d'harmoniques (A1, A2 ...) après la réception du signal de début, débute l'opération lorsqu'une tension d'une seule phase parmi les tensions détectées atteint une valeur prescrite un nombre de fois prescrit.

14. Système de mesure d'harmoniques selon l'une des revendications 1 et 3, dans lequel l'unité de commande (5) transmet des signaux de début en tant qu'instruction de début d'opération à toutes les unités de mesure d'harmoniques en même temps, et chacune des unités de mesures d'harmoniques (A1, A2 ...) débute l'opération après un écoulement d'un temps prescrit depuis la réception du signal de début.

15. Système de mesure d'harmoniques selon l'une des revendications 1 et 3 comprenant une ligne de transmission (8) entre les unités de mesure d'harmoniques respectives (A1, A2 ...) et l'unité de commande (5), dans lequel chacune des unités de mesure d'harmoniques (A1, A2 ...) reçoit l'instruction de début d'opération et, conformément à l'instruction de transmission de résultat d'opération transmet le résultat de l'opération par l'intermédiaire de la ligne de transmission (8) à l'unité de commande (5), et l'unité de commande (5) transmet l'instruction de début d'opération aux unités de mesure d'harmoniques respectives par l'intermédiaire de la ligne de transmission (8) et, après la transmission de l'instruction de début d'opération, transmet l'instruction de transmission de résultat d'opération aux unités de mesure d'harmoniques respectives (A1, A2 ...) par l'intermédiaire de la ligne de transmission (8) et, détecte les états de génération des harmoniques sur la base des résultats de l'opération transmis depuis les unités de mesure d'harmoniques respectives (A1, A2 ...).

16. Système de mesure d'harmoniques selon l'une des revendications 1 et 3, dans lequel chacune des unités de mesure d'harmoniques (A1, A2 ...) mémorise le résultat de l'opération de celle-ci dans un support de mémorisation d'informations, et l'unité de commande (5) lit les résultats de l'opération à partir du support de mémorisation d'informations dans lequel l'unité de mesure d'harmoniques mémorise le résultat de l'opération, et détecte un état de génération des harmoniques sur la base du résultat de l'opération lu.

17. Système de mesure d'harmoniques selon l'une quelconque des revendications 1 à 9 comprenant l'unité de commande (5) à l'intérieur de l'une des plusieurs unités de mesure d'harmoniques (A1, A2 ...).

**Fig.1**

EP 0 826 972 B1

**Fig.2**

# Fig.3

t0 : point when start signal is received
t1 : point when input voltage V becomes zero at the first time

## Fig.4

```
            ┌─────────────┐
            │    Start    │
            └──────┬──────┘
                   │
                   ▼
        ┌──────────────────────┐
        │ Calculate current    │ ── S1
        │ within distribution  │
        │ line section         │
        └──────────┬───────────┘
                   │
                   ▼
        ┌──────────────────────┐
        │ Calculate admittance │ ── S2
        │ within distribution  │
        │ line section         │
        └──────────┬───────────┘
                   │
                   ▼
        ┌──────────────────────┐
        │ Form correlation     │ ── S3
        │ diagram between      │
        │ conductance and      │
        │ susceptance          │
        └──────────┬───────────┘
                   │
                   ▼
        ┌──────────────────────┐
        │ Derive regression    │ ── S4
        │ line                 │
        └──────────┬───────────┘
                   │
                   ▼
```

Compare regression lines :
intercept k1 relative to fundamental
= intercept kn/n relative to n-th harmonic?
angle m1 relative to fundamental
= angle mn · n relative to n-th harmonic? — S5

NO

YES

S6

No harmonic source within the section

S7

Harmonic source within the section

Fig.5

Fig.6

## Fig.7

regression line
b = 0.04213 − 0.38615 ∗ g

## Fig.8

Fig.9

A1,A2

3

phase-locked
loop circuit — 17

11   2

optical
PT

amplifier — 13

optical
CT

amplifier — 14

12

low-pass
filter

15   16

low-pass
filter

AD
converter

18   19

AD
converter

high-voltage
distribution
line 1

operation
unit — 20

24

clock

modem — 4

8

Fig.10

## Fig.11

distribution line section S1

distribution line section Sn

harmonic measuring unit A1

harmonic measuring unit A2

harmonic measuring unit An

harmonic measuring unit An+1

control unit 5

## Fig.12

Prior Art

current sensor 27

high-voltage distribution line 1

current sensor 26

voltage sensor 25

voltage sensor 24

29

synchronizing signal transmission cable 30

28

analyzer

analyzer

33

personal computer

RS-232C reverse cable 32

RS-232C reverse cable 31

Fig.13   Prior Art